# EUROPÄISCHE PATENTSCHRIFT

(11) **EP 3 650 970 B1**
(45) Veröffentlichungstag und Bekanntmachung des Hinweises auf die Patenterteilung: **29.12.2021**
(21) Anmeldenummer: 18205462.7
(22) Anmeldetag: 09.11.2018
(51) Int. Cl.: G05B 19/418, G05B 17/02

(54) **VERFAHREN UND VORRICHTUNG ZUM COMPUTERGESTÜTZTEN SIMULIEREN EINES MODULAREN TECHNISCHEN SYSTEMS**
METHOD AND DEVICE FOR THE COMPUTER-ASSISTED SIMULATION OF A MODULAR TECHNICAL SYSTEM
PROCÉDÉ ET DISPOSITIF DE SIMULATION ASSISTÉE PAR ORDINATEUR D'UN SYSTÈME TECHNIQUE MODULAIRE

(43) Veröffentlichungstag der Anmeldung: 13.05.2020
(73) Patentinhaber: Siemens Aktiengesellschaft, 80333 München (DE); Technische Universität Dresden, 01069 Dresden (DE)
(72) Erfinder: Botero Halblaub, Andrés, 85614 Kirchseeon (DE); Brandstetter, Veronika, 81673 München (DE); Graube, Markus, 01159 Dresden (DE); Heinzerling, Till, 76185 Karlsruhe (DE); Hensel, Stephan, 01157 Dresden (DE); Klose, Anselm, 01277 Dresden (DE); Maedler, Jonathan, 01127 Dresden (DE); Schenk, Tim, 84034 Landshut (DE); Urbas, Leon, 10713 Berlin (DE); Wehrstedt, Jan Christoph, 81829 München (DE)
(74) Vertreter: Maier, Daniel Oliver

(56) Entgegenhaltungen:
- WO-A2-2011/026021
- Martin Bergert ET AL: "Durchgängige Verhaltensmodellierung von Betriebsmitteln zur Erzeugung digitaler Simulationsmodelle von Fertigungssystemen", atp edition - Automatisierungstechnische Praxis Bd. 50 Nr. 07 (2008), 1. Juli 2008 (2008-07-01), Seiten 61-66, XP055593046, Gefunden im Internet: URL:http://ojs.di-verlag.de/index.php/atp_ edition/article/view/2058 [gefunden am 2019-05-29]
- Deliverable D1: "AVANTI - Test methodology for virtual commissioning based on behaviour simulation of production systems", , 30. April 2014 (2014-04-30), XP055179868, Gefunden im Internet: URL:http://www.avanti-project.de/files/AVA NTI_D1_1_State_of_the_Art_public.pdf [gefunden am 2015-03-27]

## Beschreibung

Die Erfindung betrifft ein Verfahren und eine Vorrichtung zum computergestützten Simulieren eines modularen technischen Systems, wobei für ein jeweiliges reales Modul des technischen Systems ein entsprechendes virtuelles Modul generiert wird.

Modulare Prozessanlagen können insbesondere vermehrt in der Verfahrenstechnik, wie z.B. in der chemischen oder pharmazeutischen Industrie, eingesetzt werden. Es werden hierfür in der Regel verfahrenstechnische Module, auch als modulare Prozesseinheit (engl. Process Equipment Module) bezeichnet, verwendet, die in sich abgeschlossen sind und sich von einem Modulintegrator zu komplexen Gesamtanlagen verschalten lassen. Die Zusammenschaltung von Modulen ermöglicht eine Reduzierung der Planungs- und Umbauzeit neuer Anlagen. Die Module können in der Regel jeweils eine eigene Steuerungs- bzw. Automatisierungstechnik umfassen, die beim Betrieb der modularen Anlage von einer zentralen Prozessorchestrierungsebene (engl. Process Orchestration Layer) Fähigkeits-basiert bzw. modulübergreifend ohne Prozessorchestrierungsebene angesteuert werden können. Zur Beschreibung der Modultypen können Standardbeschreibungssprachen, wie beispielsweise das Standard Module Type Package, kurz MTP, genutzt werden, die die Schnittstellen, Services und Funktionen der Automatisierungstechnik der Module beschreibt und die Integration der Module in eine Prozessorchestrierungsebene ermöglicht.

Vor einer realen Inbetriebnahme einer modularen Prozessanlage kann eine virtuelle Inbetriebnahme erfolgen. Diese kann beispielsweise mittels echter ("Hardware-in-the-Loop", kurz HiL) oder emulierter Steuerung ("Software-in-the-Loop", kurz SiL, oder "Model-in-the-Loop", kurz MiL) und/oder als eine Simulation des Prozessverhaltens realisiert sein. Somit werden für die virtuelle Inbetriebnahme für jedes Modul Simulationsmodelle des Prozesses und Emulationen der Automatisierungstechnik benötigt, welche entsprechend der Anlagentopologie orchestriert werden können. In der Regel liegen die benötigten Simulationsmodelle und Emulationen nicht vor, werden vom Modul-Hersteller nicht mitgeliefert und/oder basieren auf unterschiedlicher Software. Eine virtuelle Inbetriebnahme einer Anlage aus Modulen verschiedener Hersteller ist demnach mit viel Aufwand verbunden bzw. unmöglich, da die im Modul integrierte Automatisierungstechnik und/oder der Prozess nur einem Hersteller bekannt sein kann.

Aus WO2011/026021A2 ist ein Verfahren zur Erstellung eines funktionsbasierten mechatronischen Objekts für einen funktionsbasierten Design-Ansatz bekannt.

In Martin Bergert et al. "Durchgängige Verhaltensmodellierung von Betriebsmitteln zur Erzeugung digitaler Simulationsmodelle von Fertigungssystemen" atp edition - Automatisierungstechnische Praxis Bd. 50 Nr. 07 (2008), 1. Juli 2008 (2008-07-01), Seiten 61-66 werden insbesondere mechatronische Anlagenmodelle beschrieben.

In AVANTI - Test methodology for virtual commissioning based on behaviour simulation of production systems", 30. April 2014 (2014-04-30*) wird ein Projekt zur Verbesserung der virtuellen Inbetriebnahme von Anlagensystemen vorgeschlagen.*

Es ist eine Aufgabe der vorliegenden Erfindung, eine virtuelle Inbetriebnahme eines modularen technischen Systems, insbesondere einer modularen Prozessanlage, zu erleichtern.

Die Aufgabe wird durch die in den unabhängigen Ansprüchen beschriebenen Maßnahmen gelöst. In den abhängigen Ansprüchen sind vorteilhafte Weiterbildungen der Erfindung dargestellt.

Gemäß einem ersten Aspekt betrifft die Erfindung ein Verfahren zum computergestützten Simulieren eines modularen technischen Systems, wobei mittels eines Prozessors für ein jeweiliges reales Modul des modularen technischen Systems
a) modulspezifische Daten des realen Moduls eingelesen und abhängig von den modulspezifischen Daten ein entsprechendes virtuelles Modul generiert wird, das
   - eine Steuerung zum Steuern eines modulspezifischen Prozesses
   und
   - mindestens ein modulspezifisches Simulationsmodell, dem eine Modelltypinformation zugeordnet ist, zur Simulation des modulspezifischen Prozesses,
   umfasst und das derart eingerichtet wird, den durch die Steuerung gesteuerten modulspezifischen Prozess mittels des modulspezifischen Simulationsmodells und/oder die Steuerung des realen Moduls nachzubilden,
   und
b) das virtuelle Modul für eine computergestützte Simulation des modularen technischen Systems als Datencontainer bereitgestellt wird.

Das erfindungsgemäße Verfahren kann insbesondere als computerimplementiertes Verfahren realisiert sein. Insbesondere kann das Verfahren von einer Vorrichtung, die mindestens einen Prozessor umfasst, durchgeführt werden.

Unter einem "Prozessor" kann im Zusammenhang mit der Erfindung beispielsweise eine Maschine oder eine elektronische Schaltung verstanden werden. Bei einem Prozessor kann es sich insbesondere um einen Hauptprozessor (engl. Central Processing Unit, CPU), einen Mikroprozessor oder einen Mikrokontroller, beispielsweise eine anwendungsspezifische integrierte Schaltung oder einen digitalen Signalprozessor, möglicherweise in Kombination mit einer Speichereinheit zum Speichern von Programmbefehlen, ein Server etc. handeln.

Unter einem "modularen technischen System" kann im Zusammenhang mit der Erfindung insbesondere eine modulare Anlage, eine modulare Prozessanlage, oder eine modulare Produktionsanlage verstanden werden. Das modulare technische System umfasst mindestens ein Modul. Unter einem "Modul" kann im Zusammenhang mit der Erfindung insbesondere ein Hardware-Modul, eine Subanlage oder ein Anlagenmodul, wie z.B. Geräte oder Pumpen, verstanden werden. Ein Modul kann auch als modulare Prozesseinheit (engl. Process Equipment Module) bezeichnet werden. Bestandteile eines Moduls können insbesondere Aktoren, Sensoren, prozesstechnische Anschlüsse, Ansteuerungs- und Kommunikationsschnittstellen und eine eigene Automatisierungstechnik sein.

Ein "virtuelles Modul" kann im Zusammenhang mit der Erfindung als Datencontainer, insbesondere mit einer festen (Daten-)Struktur, als ein vorgegebenes Austauschformat oder als eine Datenstruktur, die insbesondere teilweise ausführbar sein kann, verstanden werden. Ein virtuelles Modul bildet insbesondere ein reales Modul ab, d.h. es umfasst virtuelle bzw. simulierte Bestandteile des realen Moduls. Insbesondere kann das virtuelle Modul mindestens eine Steuerung und ein modulspezifisches Simulationsmodell umfassen, wobei jeweils mindestens eine Beschreibung, z.B. zu Details und Ausführbarkeit, zugeordnet wird. Die Steuerung und das mindestens eine Simulationsmodell des virtuellen Moduls können vorzugsweise über eine Kommunikationsebene im virtuellen Modul miteinander gekoppelt sein, so dass beispielsweise Steuerdaten von der Steuerung an das Simulationsmodell übertragen werden können.

Unter einer "computergestützten Simulation" kann insbesondere eine Simulation des Betriebs und/oder der Prozesse eines modularen technischen Systems und/oder eine virtuelle Inbetriebnahme verstanden werden. Eine virtuelle Inbetriebnahme umfasst beispielsweise verschiedene Tests, wie z.B. Signaltests, Test der Feldgeräte oder des Prozessverhaltens. Beim Test des Prozessverhalten können insbesondere verschiedene prozessierte Medien oder Stoffe, modelliert werden. Des Weiteren können mittels einer virtuellen Inbetriebnahme die Steuerung bzw. Automatisierungstechnik eines Moduls bzw. der gesamten Anlage getestet werden. Dabei kann insbesondere lediglich die reale Automatisierungs- bzw. Steuerungshardware genutzt werden, d.h. es kann ein sogenannter "Hardware-in-the-Loop"-Ansatz realisiert werden. Alternativ kann auch eine Emulation der Automatisierungs- bzw. Steuerungstechnik, d.h. sogenannte "Software-in-the-Loop" oder "Model-in-the-Loop" Ansätze realisiert werden. Dazu umfasst das virtuelle Modul eine Steuerung, die auch als virtuelle Steuerung bezeichnet werden kann, und die insbesondere als Hardware-Projekt oder als Emulation vorliegen kann. Wenn die Steuerung des virtuellen Moduls als Hardware-Projekt vorliegt, kann das virtuelle Modul mit einer realen Steuerung, die der Steuerung des realen Moduls zumindest entspricht, gekoppelt werden. Alternativ kann im virtuellen Modul die Steuerung auch als Emulation vorliegen.

Vorzugsweise kann ein erfindungsgemäßes virtuelles Modul für ein jeweiliges reales Modul von einem Modul-Hersteller generiert und mitgeliefert werden. Es werden Daten, insbesondere modulspezifische Daten, wie z.B. Konfigurations- und/oder Spezifikationsdaten, des realen Moduls ermittelt und eingelesen. Die Daten können beispielsweise mittels eines Sensors erfasst oder aus einer Beschreibung des realen Moduls abgeleitet werden. In Abhängigkeit dieser modulspezifischen Daten wird das virtuelle Modul generiert. Insbesondere umfasst das virtuelle Modul mindestens ein modulspezifisches Simulationsmodell zusammen mit einer zugeordneten Modelltypinformation. Das Simulationsmodell umfasst beispielsweise Informationen zur Prozesstechnik, zu Aktoren oder Sensoren, zu prozesstechnische Anschlüsse, Kommunikation zur Steuerung, simulierte physikalische Schnittstellen und Ansteuermöglichkeiten, Ein-Ausgabe-Schnittstellen für modellübergreifenden Austausch von Variablen oder Parametern und ähnliches. Das modulspezifische Simulationsmodell kann insbesondere vorgeneriert und/oder vorkonfiguriert und derart bereitgestellt werden. Beispielsweise kann ein Modulhersteller mindestens ein entsprechendes Simulationsmodell generieren. Vorzugsweise umfasst das virtuelle Modul eine Vielzahl von modulspezifischen Simulationsmodellen, denen jeweils eine Modelltypinformation zugeordnet ist, um z.B. auf einfache Weise verschiedenartige Simulationen durchführen zu können.

Das modulspezifische Simulationsmodell und/oder die Steuerung des virtuellen Moduls kann beispielsweise auch als Link auf eine Hersteller-Homepage und/oder eine IP-Adresse zum direkten Ausführen auf einem Hersteller-Server realisiert sein.

Es ist ein Vorteil der vorliegenden Erfindung, dass ein virtuelles Modul die notwendigen Informationen umfasst, um auf einfache Weise eine modulare Anlage in einer Simulationsumgebung virtuell zu konfigurieren und zu simulieren. Beispielsweise kann bei einer Änderung in einer Konfiguration der realen modularen Anlage mittels virtueller Module eine Prüfung der Anlagenkonfiguration virtuell durchgeführt werden.

Aufgrund einer standardisierten Methodik und einer spezifizierten Kapselung der einzelnen Bestandteile des virtuellen Moduls in einem Datencontainer kann das Erstellen einer virtuellen Inbetriebnahme eines modularen technischen Systems automatisiert werden und es ist insbesondere möglich, diese unabhängig von einer spezifischen Simulationssoftware zu realisieren. Ein Modellierungsaufwand kann verringert und/oder Modellierungsfehler können vermieden werden, da das virtuelle Modul alle benötigten Informationen für eine Simulation der modularen Anlage umfassen kann, die als Datencontainer bereitgestellt werden. Bei realen Modulen verschiedener Hersteller kann ohne weiteren Aufwand und/oder spezifischer Simulationstools das Erstellen einer virtuellen Inbetriebnahme erfolgen.

In einer vorteilhaften Ausführungsform des Verfahrens kann die Modelltypinformation Angaben zum Typ des Simulationsmodells, zur Ausführung und/oder zur Detailgenauigkeit des Simulationsmodells umfassen.

Eine Modelltypinformation kann insbesondere als eine Beschreibung des jeweiligen modulspezifischen Simulationsmodells verstanden werden. Um beispielsweise eine automatisierte Integration der modulspezifischen Simulationsmodelle in die Simulationsumgebung zu erreichen, ist es vorteilhaft eine genaue Beschreibung eines modulspezifischen Simulationsmodells mitzuliefern.

In einer vorteilhaften Ausführungsform des Verfahrens kann das modulspezifische Simulationsmodell eine erste Schnittstelle aufweisen, über die modellübergreifende Variablen des modulspezifischen Simulationsmodells ausgetauscht werden.

Insbesondere kann jedes modulspezifische Simulationsmodell, das im virtuellen Modul integriert ist, mindestens eine erste Schnittstelle aufweisen. Über die erste Schnittstelle können insbesondere Variablen modellübergreifend ausgetauscht werden. Variablen können dabei als modulübergreifend oder modulintern definiert sein und beispielsweise physikalische Größen oder Signale umfassen. Über die erste Schnittstelle kann vorzugsweise eine Kopplung mit anderen virtuellen Modulen aufgebaut werden, um beispielsweise das modulare technische System virtuell aufzusetzen. Die erste Schnittstelle umfasst somit insbesondere diejenigen Kopplungen, um z.B. Signale oder physikalische Größen auszutauschen, die das reale Modul ebenso aufweist.

In einer vorteilhaften Ausführungsform des Verfahrens kann das modulspezifische Simulationsmodell eine zweite Schnittstelle aufweisen, über die Parameterwerte und/oder Funktionen für das modulspezifische Simulationsmodell eingelesen werden können und das modulspezifische Simulationsmodell damit konfiguriert wird.

Insbesondere kann jedes modulspezifische Simulationsmodell, das im virtuellen Modul integriert ist, mindestens eine zweite Schnittstelle aufweisen. Über diese zweite Schnittstelle können insbesondere Parameterwerte und/oder Funktionen und/oder sekundäre Simulationsmodelle eingelesen werden. Sekundäre Simulationsmodelle können beispielsweise in Funktionen gekapselt und derart von einem modulspezifischen Simulationsmodell aufgerufen werden. Ein sekundäres Simulationsmodell kann beispielsweise eine Simulation einer Reaktionskinetik umfassen. Beispielsweise können über die zweite Schnittstelle kundenspezifische Parameterwerte, parametrisierte Funktionen oder ähnliches für ein Simulationsmodell eingegeben werden. Insbesondere kann ein Zugriff auf eine Datenbank realisiert werden. Das modulspezifische Simulationsmodell kann mittels der Eingaben über die zweite Schnittstelle konfiguriert und anschließend ausgeführt werden.

In einer vorteilhaften Ausführungsform des Verfahrens kann das modulspezifische Simulationsmodell eine dritte Schnittstelle zur modulübergreifenden Kommunikation umfassen und über die dritte Schnittstelle können Zustandsdaten eines modulspezifischen Simulationsmodells eingelesen und/oder ausgelesen werden.

Vorzugsweise umfasst das virtuelle Modul analog zum realen Modul mindestens eine dritte Schnittstelle. Eine dritte Schnittstelle kann beispielsweise als eine Kommunikationsschnittstelle, eine Bedienschnittstelle (engl. Human-Maschine-Interface) oder eine Verbindung zu einer zentralen Steuerungs- oder Prozessorchestrierungsebene realisiert sein. Über die dritte Schnittstelle können insbesondere Zustandsdaten, die für eine virtuelle Inbetriebnahme benötigt werden, ausgetauscht werden. Beispielsweise können Fehlerzustände ausgelesen oder gesetzt werden. Die dritte Schnittstelle ermöglich insbesondere eine Datenübertragung bzw. einen Datenaustausch, wie z.B. die Eingabe von Steuerbefehlen. Außerdem ermöglicht die dritte Schnittstelle eine Eingabe von Zustandsdaten und/oder eine Ausgabe von Zustandsdaten eines Simulationsmodells. Zustandsdaten umfassen insbesondere Zustände eines Simulationsmodells zu einem bestimmten Zeitpunkt. Beispielsweise lassen sich derart Fehler- und/oder Validierungszustände des Simulationsmodells setzen und/oder auslesen.

In einer vorteilhaften Ausführungsform des Verfahrens können Zustandsdaten eines modulspezifischen Simulationsmodells über eine Auswerteeinheit ausgegeben werden.

Eine Auswerteeinheit kann beispielsweise ein Bedienbild zur Anzeige von Zuständen oder ähnliches sein. Insbesondere können interne Zustandsdaten eines Simulationsmodells angezeigt werden.

In einer vorteilhaften Ausführungsform des Verfahrens kann ein weiteres modulspezifisches Simulationsmodell, dem eine weitere Modelltypinformation zugeordnet ist, im virtuellen Modul integriert werden.

Das virtuelle Modul ist vorzugsweise derart eingerichtet, dass weitere modulspezifische Simulationsmodelle eingebunden werden können. Dies ermöglicht beispielsweise weitere Simulationstypen mittels des virtuellen Moduls aufzusetzen.

In einer vorteilhaften Ausführungsform des Verfahrens kann das virtuelle Modul gekapselt und/oder verschlüsselt werden und derart bereitgestellt werden.

Das virtuelle Modul kann beispielsweise als gekapselter und/oder verschlüsselter Datencontainer bereitgestellt werden. Es kann insbesondere ein bekanntes Verfahren zur Datenkapselung und/oder kryptografischen Verschlüsselung von Daten genutzt werden.

In einer vorteilhaften Ausführungsform des Verfahrens können
a) abhängig von einer vorgegebenen Konfigurationsinformation des modularen technischen Systems reale Module des technischen Systems selektiert, für die selektierten realen Modulen entsprechende virtuelle Module bereitgestellt und in eine Simulationsumgebung eingelesen werden,
   und
b) die virtuellen Module abhängig von der Konfigurationsinformation in der Simulationsumgebung miteinander gekoppelt werden und es kann eine computergestützte Simulation des modularen technischen Systems ausgeführt werden, wobei abhängig von einer vorgegebenen Simulationstypinformation für jedes virtuelle Modul ein durch die jeweilige Steuerung gesteuerter modulspezifischer Prozess mittels des jeweiligen modulspezifischen Simulationsmodells, dessen zugeordnete Modelltypinformation der Simulationstypinformation genügt, und/oder die Steuerung eines jeweiligen modulspezifischen Prozesses nachgebildet wird.

Eine Simulationstypinformation kann insbesondere von einem Anlagenintegrator abhängig von den Anforderungen an die Simulation des modularen technischen Systems bereitgestellt oder vorgegeben sein. Sie umfasst beispielsweise die Art des Tests, wie z.B. Signaltest, Feldgerätetest, oder Automatisierungstest.

Das modulare technische System kann in einer Simulationsumgebung oder einem Simulator mittels der virtuellen Module für jedes vorhandene reale Modul simuliert werden. Die virtuellen Module umfassen vorzugsweise alle Informationen, die für das Aufsetzen und Durchführen einer Simulation benötigt werden. Die Konfiguration und/oder Topologie der virtuellen Anlage aus den virtuellen Modulen erfolgt gemäß der Konfigurationsinformation der realen Anlage. Insbesondere kann anhand eines Vergleichs der Simulationstypinformation und der Modelltypinformationen das benötigte Simulationsmodell ermittelt werden.

In einer vorteilhaften Ausführungsform des Verfahrens kann das technische System abhängig von einem Ergebnis der ausgeführten Simulation der Module konfiguriert und/oder gesteuert werden.

Ein weiterer Aspekt der Erfindung betrifft eine Vorrichtung zum computergestützten Simulieren eines modularen technischen Systems, die mindestens einen Prozessor aufweist, der zum Ausführen eines erfindungsgemäßen Verfahrens eingerichtet ist.

Des Weiteren betrifft die Erfindung ein Computerprogrammprodukt, das direkt in einen programmierbaren Computer ladbar ist, umfassend Programmcodeteile, die bei der Ausführung des Programms durch einen Computer diesen veranlassen, das Verfahren/die Schritte eines Verfahrens auszuführen und ein computerlesbares Speichermedium mit einem erfindungsgemäßen Computerprogrammprodukt.

Ein Computerprogrammprodukt kann beispielsweise auf einem Speichermedium, wie z.B. Speicherkarte, USB-Stick, CD-ROM, DVD, ein nichtflüchtiger/dauerhaftes Speichermedium (engl. Non-transitory storage Medium) oder auch in Form einer herunterladbaren Datei von einem Server in einem Netzwerk bereitgestellt oder geliefert werden.

Ausführungsbeispiele des erfindungsgemäßen Verfahrens und der erfindungsgemäßen Vorrichtung sind in den Figuren beispielhaft dargestellt und werden anhand der nachfolgenden Beschreibung näher erläutert. Es zeigen:
- Fig. 1:: ein Ablaufdiagramm eines erfindungsgemäßen Verfahrens;
- Fig. 2:: eine schematische Darstellung einer erfindungsgemäßen Vorrichtung; und
- Fig. 3:: eine schematische Darstellung eines Aufbaus eines in einer Simulationsumgebung integrierten virtuellen Moduls.

Einander entsprechende Gegenstände sind in allen Figuren mit den gleichen Bezugszeichen versehen.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des/der Verfahrensanspruchs/Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf. Insbesondere können diese gebräuchlichen und dem Fachmann bekannten Realisierungsvarianten ausschließlich per Hardware(komponenten) oder ausschließlich per Software (komponenten) realisiert werden. Alternativ und/oder zusätzlich kann der Fachmann im Rahmen seines fachmännischen Könnens weitestgehend beliebige erfindungsgemäße Kombinationen aus Hardware(komponenten) und Software(komponenten) wählen, um erfindungsgemäße Realisierungsvarianten umzusetzen.

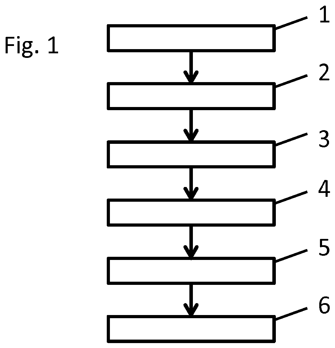

Figur 1 zeigt ein Ausführungsbeispiel eines erfindungsgemäßen Verfahrens zum computergestützten Simulieren eines modularen technischen Systems. Ein modulares technisches System kann insbesondere eine modular aufgebaute Prozessanlage, beispielsweise für die chemische oder pharmazeutische Industrie sein. Das Verfahren kann insbesondere als ein computerimplementiertes Verfahren realisiert sein, wobei zumindest teilweise Schritte des Verfahrens von einem Prozessor ausgeführt werden.

Ein modulares technisches System kann mehrere Module umfassen, die austauschbar konfiguriert sein können. Die Module können insbesondere jeweils eine eigene Steuerungs- bzw. Automatisierungstechnik umfassen, die beispielsweise Sensoren und/oder Aktoren des Moduls ansteuert. Vorzugsweise können verschiedene Module über physikalische Schnittstellen miteinander gekoppelt werden. Ein Modul kann beispielsweise einen Prozessschritt eines Prozesses und/oder lediglich einen Teil eines Prozessschrittes realisieren. Die Steuerung eines Prozesses eines modularen technischen Systems kann insbesondere über eine zentrale Prozessorchestrierungsebene gesteuert werden, die die Steuerung eines jeweiligen Moduls ansteuert.

Vor einer Inbetriebnahme des modularen technischen Systems kann vorzugsweise eine Simulation des technischen Systems, d.h. eine virtuelle Inbetriebnahme, erfolgen. Dies kann beispielsweise ein reiner Signaltest, ein Test der Feldgeräteschicht, ein Test der Prozessdynamik, oder ein transienter Test des Prozessverhaltens sein. Dabei können insbesondere verschiedene Bedienhandlungen, verschiedene Systemspezifikationen und/oder Fehlerszenarien durchgespielt werden. Eine virtuelle Inbetriebnahme kann in einer geeigneten Engineeringumgebung oder Simulationsumgebung erfolgen.

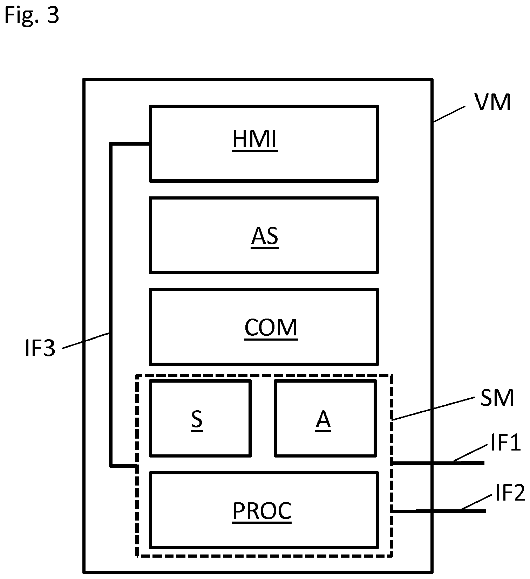

Im ersten Schritt S1 eines erfindungsgemäßen Verfahrens wird für ein jeweiliges reales Modul des modularen technischen Systems ein virtuelles Modul in Abhängigkeit von modulspezifischen Daten des entsprechenden realen Moduls generiert. Die modulspezifischen Daten des realen Moduls können beispielsweise Konfigurationsdaten oder Spezifikationsdaten sein. Ein virtuelles Modul kann als ein Datencontainer, insbesondere als eine Datenstruktur, eine ausführbare Datenstruktur mit einer fest vorgegebenen Struktur realisiert sein, wie beispielhaft in Figur 3 dargestellt.

Ein virtuelles Modul wird insbesondere derart eingerichtet, dass es einen modulspezifischen Prozess mittels eines modulspezifischen Simulationsmodells und/oder die Steuerung des entsprechenden realen Moduls nachbilden bzw. simulieren kann. Da ein virtuelles Modul sowohl eine Steuerung als auch mindestens ein modulspezifisches Simulationsmodell umfasst, kann damit eine Simulation des entsprechenden realen Moduls in einer Simulationsumgebung aufgesetzt werden.

Ein virtuelles Modul umfasst vorzugsweise eine Mehrzahl an modulspezifischen Simulationsmodellen, denen jeweils eine Modelltypinformation zugeordnet ist. Die modulspezifischen Simulationsmodelle können insbesondere vorab generiert werden. Sie bilden beispielsweise einen im Modul ablaufenden Prozess ab.

Des Weiteren umfasst das virtuelle Modul eine emulierte Steuerung oder ein Steuerprojekt inklusive einer Schnittstelle zur Anbindung an eine reale Steuerung zum Steuern eines modulspezifischen Prozesses. Außerdem kann das virtuelle Modul eine dritte Schnittstelle zur modulübergreifenden Kommunikation umfassen. Über die dritte Schnittstelle kann das virtuelle Modul insbesondere in einer Simulationsumgebung mit anderen virtuellen Modulen zu einer virtuellen Anlage verschaltet werden. Außerdem erlaubt die dritte Schnittstelle einen Datenaustausch über Modulgrenzen hinweg, wie z.B. das Ausgeben von Zustandsdaten eines modulspezifischen Simulationsmodells an eine Auswerteeinheit.

Das virtuelle Modul wird jeweils analog zum realen Modul generiert, d.h. das virtuelle Modul umfasst insbesondere ein Abbild aller Ansteuermöglichkeiten, Schnittstellen, Fähigkeiten und Funktionen wie das reale Modul und erlaubt demnach, eine Simulation des gesamten modularen technischen Systems zu realisieren. Insbesondere umfasst das virtuelle Modul eine Vielzahl an verschiedene Simulationsmodellen mit verschiedenen Modelltypinformationen, so dass beispielsweise verschiedenartige Simulationen des Moduls und/oder der modularen Anlage durchgeführt werden können. Des Weiteren umfasst das virtuelle Modul eine Steuerung, die beispielsweise als emulierte Steuerung ausgebildet sein kann. Das virtuelle Modul kann insbesondere als gekapselter und/oder verschlüsselter Datencontainer bereitgestellt werden.

Ein virtuelles Modul ist vorzugsweise derart eingerichtet, dass es in einer Simulationsumgebung zusammen mit anderen virtuellen Modulen zu einem virtuellen technischen System zusammengesetzt werden kann. Ein virtuelles Modul umfasst dabei eine moduleigene Steuerung und mindestens ein modulspezifisches Simulationsmodell, die über eine Kommunikationsebene miteinander vorteilhaft gekoppelt sind, so dass das reale Modul, die Steuerung des realen Moduls und/oder ein Prozess des realen Moduls simuliert werden kann.

Vorzugsweise stellt ein Hersteller eines realen Moduls einer prozesstechnischen Anlage zusammen mit einer standardisierten Beschreibung, wie z.B. einer MTP-Beschreibung, des realen Moduls ein jeweiliges virtuelles Modul als Datencontainer bereit, Schritt S2. Beispielsweise können die virtuellen Module auf einer Speichereinheit, einer Datenbank oder auf einem Server gespeichert werden.

Im Folgenden kann die Simulation des modularen technischen Systems aufgesetzt und ausgeführt werden. Dazu wird im nächsten Schritt S3 für ein zu simulierendes modulares technisches System alle realen Module identifiziert und für diese entsprechende virtuelle Module bereitgestellt. Dies erfolgt abhängig von einer vorgegebenen Konfigurationsinformation des modularen technischen Systems, die z.B. Informationen über die Anlagentopologie aus der Prozessorchestrierungsebene, Informationen über Verknüpfungen der Module und deren Variablenaustausch und/oder Informationen aus z.B. der MTP-Beschreibung umfasst. Außerdem wird in Schritt S3 anhand einer vorgegebenen Simulationstypinformation bestimmt, welche Art von Simulation und/oder welche Art von Steuerung ausgeführt werden soll.

Die bereitgestellten virtuellen Module werden in eine geeignete Simulationsumgebung eingelesen. Beispielsweise kann ein Inbetriebnehmer oder Anlagenintegrator einer modularen Prozessanlage die virtuellen Module in eine geeignete Engineeringumgebung einlesen.

Im nächsten Schritt S4 werden die virtuellen Module abhängig von der Konfigurationsinformation in der Simulationsumgebung miteinander gekoppelt, d.h. Schnittstellen der Simulationsmodelle werden derart miteinander verbunden, dass Variablen ausgetauscht werden können. Ein Inbetriebnehmer oder Anlagenintegrator kann somit abhängig von der Konfigurationsinformation ein virtuelles Abbild des modularen technischen Systems aufsetzen. Dazu werden insbesondere jeweils das Simulationsmodell eines jeweiligen virtuellen Moduls ausgewählt, dessen Modelltypinformation einer vorgegebenen Simulationstypinformation entspricht bzw. genügt. Die Simulationstypinformation bestimmt insbesondere die Art der virtuellen Inbetriebnahme, wie z.B. Signaltest, Prozesstest, Hardware-in-the-Loop, Software-in-the-Loop oder Model-in-the-Loop für die Steuerung. Außerdem wird abhängig von der Simulationstypinformation ermittelt, welche Art von Steuerung konfiguriert wird.

Die virtuellen Module werden in der Simulationsumgebung miteinander verschaltet, wobei für ein jeweiliges virtuelles Modul gemäß der Simulationstypinformation die entsprechenden Simulationsmodelle und/oder der entsprechende Steuerungstyp ausgewählt und konfiguriert werden.

Vor der Ausführung der Simulation, d.h. vor einer virtuellen Inbetriebnahme, können vom Anlagenintegrator für die jeweiligen modulspezifischen Simulationsmodelle über deren jeweils zweite Schnittstelle Parameterwerte und/oder Funktionen gesetzt werden, Schritt S4. Insbesondere können Parameter und/oder Funktionen definiert werden, die nicht vom Hersteller eines Moduls festgelegt sind. Beispielsweise können kundenspezifische Parameter, wie z.B. Stoffdaten, eingelesen und das jeweilige modulspezifische Simulationsmodell entsprechend konfiguriert werden.

Das modulare technische System kann mittels der aufgesetzten Simulation auf Basis der virtuellen Module simuliert werden. Insbesondere können verschiedene Fehlerszenarien und/oder das Prozessverhalten computergestützt simuliert werden, Schritt S5. Dabei können interne Zustandsdaten eines modulspezifischen Prozesssimulationsmodells an eine Auswerteeinheit, wie z.B. ein Bedienbild, ausgegeben werden.

Des Weiteren ist es möglich, über die dritte Schnittstelle eines jeweiligen virtuellen Moduls Zustandsdaten eines modulspezifischen Simulationsmodells aus- und einzulesen. Beispielsweise können Zustandsdaten eines modulspezifischen Prozesssimulationsmodells auf vorgegebene Werte gesetzt werden, um ein Fehlerszenario zu simulieren.

Abhängig vom Ergebnis der Simulation des modularen technischen Systems kann dieses in Betrieb genommen, gemäß der Konfigurationsinformation konfiguriert und/oder gesteuert werden. Schritt S6 des Verfahrens umfasst die Übermittlung des Ergebnisses der virtuellen Inbetriebnahme an z.B. einen Anlagenintegrator.

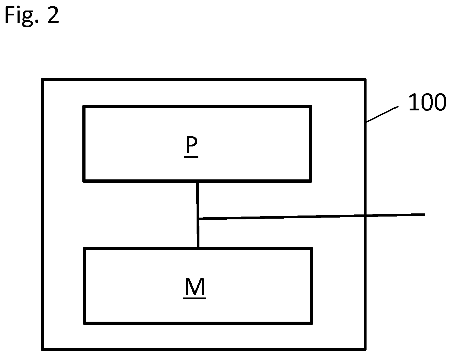

Figur 2 zeigt eine erfindungsgemäße Vorrichtung 100 in Blockdarstellung. Die Vorrichtung 100 ist derart ausgestaltet, ein erfindungsgemäßes Verfahren auszuführen. Insbesondere umfasst die Vorrichtung 100 mindestens einen Prozessor P, der mindestens einen Verfahrensschritt des Verfahrens ausführt. Des Weiteren kann die erfindungsgemäße Vorrichtung 100 mindestens eine Speichereinheit M umfassen, um insbesondere mindestens ein virtuelles Modul zu speichern und bereitzustellen.

Figur 3 zeigt in schematischer Darstellung ein virtuelles Modul VM, nach Integration in eine Simulationsumgebung, welches nach einem erfindungsgemäßen Verfahren generiert, gemäß einer Konfigurationsinformation des modularen technischen Systems mit anderen virtuellen Modulen gekoppelt wird, um eine Simulation eines modularen technischen Systems zu ermöglichen. Das virtuelle Modul VM bildet insbesondere ein entsprechendes reales Modul nach, d.h. es umfasst insbesondere alle Komponenten und Fähigkeiten eines realen Moduls und ist dabei insbesondere derart eingerichtet, verschiedene Simulationsszenarien auszuführen. Das virtuelle Modul VM ermöglicht demnach, verschiedene Simulationstypen für die virtuelle Inbetriebnahme zu realisieren. Ein virtuelles Modul VM wird als Datencontainer bereitgestellt. Vorzugsweise wird der Datencontainer mit einer vorgegebenen Struktur generiert.

Ein virtuelles Modul VM umfasst mindestens ein Simulationsmodell SM, das einen modulspezifischen Prozess PROC sowie die Anbindung an Aktoren A und/oder Sensoren S nachbildet bzw. simuliert. Das modulspezifische Simulationsmodell SM umfasst insbesondere Informationen zur Prozesstechnik, Aktoren, Sensoren, prozesstechnische Anschlüsse, Kommunikation, und Ein-Ausgabe-Schnittstellen für modellübergreifenden Austausch von Variablen/Parametern.

Das modulspezifische Simulationsmodell SM wird durch eine zugeordnete Modelltypinformation beschrieben. Vorzugsweise wird die Modelltypinformation mit dem Simulationsmodell SM bereitgestellt. Die Modelltypinformation kann beispielsweise modellübergreifend kodiert sein. Die Modelltypinformation umfasst insbesondere Angaben zum Typ des Simulationsmodells, wie z.B. Signaltest oder Prozessdynamiktest, zur Ausführung bzw. Ausführbarkeit und/oder zur Detailgenauigkeit des Simulationsmodells SM. Das virtuelle Modul VM umfasst vorzugsweise eine Vielzahl an modulspezifischen Simulationsmodellen SM, die sich jeweils beispielsweise in der Detailgenauigkeit unterscheiden.

Jedes modulspezifische Simulationsmodell SM umfasst insbesondere mindestens eine erste Schnittstelle IF1 und eine zweite Schnittstelle IF2. Die erste Schnittstelle IF1 ermöglicht den Austausch modellübergreifender Variablen des modulspezifischen Simulationsmodells SM. Modellübergreifende Variablen können insbesondere modulübergreifend und/oder modulintern ausgetauscht werden. In anderen Worten, die erste Schnittstelle IF1 kann als simulierte physikalische Schnittstelle und Ansteuermöglichkeit angesehen werden. Die zweite Schnittstelle IF2 ermöglicht insbesondere eine Konfiguration des jeweiligen Simulationsmodells SM. Die zweite Schnittstelle IF2 erlaubt damit insbesondere einen Zugriff auf das virtuelle Modul VM von außen. Das virtuelle Modul VM und/oder die Simulationsmodelle SM können insbesondere weitere Schnittstellen umfassen.

Des Weiteren umfasst das virtuelle Modul VM eine Steuerung AS, die entweder als Emulation, als Steuerungs-Projekt, als vereinfachtes Modell der Steuerungslogik bzw. vereinfachte funktionale Automatisierungslogik vorliegt. Ein Steuerungs-Projekt kann beispielsweise als Datei realisiert sein. Der Steuerung kann insbesondere eine Steuerungstypinformation zugeordnet sein, anhand der sich der Typ der Steuerung und die Fähigkeiten ableiten lassen. Eine Emulation der Steuerung kann als ein Abbild der realen Steuerung verstanden werden. Die Steuerung AS des virtuellen Moduls VM ist über eine Kommunikationsebene COM mit der Prozesssimulation gekoppelt. Die Kommunikation kann beispielsweise gemäß einem Kommunikationsprotokoll erfolgen. Außerdem ist die dritte Schnittstelle IF3 des virtuellen Moduls VM mit dem mindestens einen modulspezifischen Simulationsmodell SM gekoppelt. Über die dritte Schnittstelle IF3 können beispielsweise Zustandsdaten eines modulspezifischen Simulationsmodells SM ausgelesen und an eine Auswerteeinheit oder an ein Bedienbild HMI übermittelt werden.

Die Ausführbarkeit des Simulationsmodells SM und/oder der Steuerung AS kann insbesondere in verschiedenen Varianten vorliegen. Die Ausführung kann beispielsweise toolspezifisch erfolgen, d.h. die Ausführung benötigt ein definiertes Tool, wie z.B. eine Simulationssoftware. Alternativ kann die Ausführung toolunspezifisch erfolgen, d.h. die Simulationsmodelle und/oder die Steuerung werden gemäß einem definierten Standardformat bereitgestellt, so dass es in verschiedene Simulationstools geladen und dort ausgeführt werden kann. Außerdem können Simulationsmodelle und/oder die Steuerung derart definiert sein, dass sie selbst ausführbar bereitgestellt werden, d.h. beispielsweise als standardisiertes Executable, wofür kein spezifiziertes Tool für die Ausführung notwendig ist. Vorzugsweise wird für jedes virtuelle Modul die Ausführbarkeit der Simulationsmodelle und Steuerungsmodelle definiert.

Der Datencontainer eines virtuellen Moduls VM kann beispielsweise gemäß einer Baumstruktur strukturiert sein. Vorzugsweise sind das Format und die Struktur eines virtuellen Moduls VM für jedes virtuelle Modul gleich und somit miteinander kompatibel.

Beispielsweise kann die Baumstruktur eine Ordnerstruktur umfassen, die beispielsweise mit einer standardisierten Beschreibung wie der MTP- Beschreibung kompatibel sein kann. Beispielsweise kann in einer Ordnerebene alle verfügbaren modulspezifischen Simulationsmodelle, entsprechende Steuerungsvarianten und verfügbaren Gesamtmodelle, umfassend eine Kopplungstabelle für die Kopplung einer Steuerung und eines Simulationsmodell, aufgeführt werden. Insbesondere kann pro Simulationsmodell und Steuerung die Umsetzung, d.h. toolspezifisch, toolunspezifisch oder ausführbar, definiert werden. Jedem modulspezifischen Simulationsmodell wird eine Modelltypinformation zugeordnet, die beispielsweise als eine XML-Datei realisiert sein kann.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Verfahren zum computergestützten Simulieren eines modularen technischen Systems, insbesondere einer modularen Prozessanlage, wobei mittels eines Prozessors für ein jeweiliges reales Modul des modularen technischen Systems
a) modulspezifische Daten des realen Moduls eingelesen und abhängig von den modulspezifischen Daten ein entsprechendes virtuelles Modul (VM) generiert wird (S1), das
- eine Steuerung zum Steuern eines modulspezifischen Prozesses, die als Hardware-Projekt oder als Emulation vorliegt,
und
- mindestens ein modulspezifisches Simulationsmodell (SM), dem eine Modelltypinformation zugeordnet ist, zur Simulation des modulspezifischen Prozesses, wobei das modulspezifische Simulationsmodell (SM) eine erste Schnittstelle (IF1) aufweist, über die modellübergreifende Variablen des modulspezifischen Simulationsmodells (SM) ausgetauscht werden,
umfasst und das derart eingerichtet wird, den durch die Steuerung gesteuerten modulspezifischen Prozess mittels des modulspezifischen Simulationsmodells (SM) und/oder die Steuerung des realen Moduls nachzubilden,
und
b) das virtuelle Modul (VM) für eine computergestützte Simulation des modularen technischen Systems als Datencontainer bereitgestellt wird (S2),
wobei das virtuelle Modul (VM) als gekapselter Datencontainer bereitgestellt wird,
wobei
c) abhängig von einer vorgegebenen Konfigurationsinformation des modularen technischen Systems reale Module des technischen Systems selektiert, für die selektierten realen Modulen entsprechende virtuelle Module bereitgestellt und in eine Simulationsumgebung eingelesen werden (S3),
und
d) die virtuellen Module abhängig von der Konfigurationsinformation in der Simulationsumgebung miteinander gekoppelt werden (S4) und eine computergestützte Simulation des modularen technischen Systems ausgeführt wird (S5), wobei abhängig von einer vorgegebenen Simulationstypinformation für jedes virtuelle Modul ein durch die jeweilige Steuerung gesteuerter modulspezifischer Prozess mittels eines jeweiligen modulspezifischen Simulationsmodells (SM), dessen zugeordnete Modelltypinformation der Simulationstypinformation genügt, und/oder die Steuerung eines jeweiligen modulspezifischen Prozesses nachgebildet wird.

2. Verfahren nach Anspruch 1, wobei die Modelltypinformation Angaben zum Typ des Simulationsmodells, zur Ausführung und/oder zur Detailgenauigkeit des Simulationsmodells (SM) umfasst.

3. Verfahren nach einem der vorhergehenden Ansprüche, wobei das modulspezifische Simulationsmodell (SM) eine zweite Schnittstelle (IF2) aufweist, über die Parameterwerte und/oder Funktionen für das modulspezifische Simulationsmodell (SM) eingelesen werden und das modulspezifische Simulationsmodell (SM) damit konfiguriert wird (S4).

4. Verfahren nach einem der vorhergehenden Ansprüche, wobei das modulspezifische Simulationsmodell (SM) eine dritte Schnittstelle (IF3) zur modulübergreifenden Kommunikation umfasst und über die dritte Schnittstelle (IF3) Zustandsdaten eines modulspezifischen Simulationsmodells (SM) eingelesen und/oder ausgelesen werden.

5. Verfahren nach Anspruch 4, wobei Zustandsdaten eines modulspezifischen Simulationsmodells (SM) über eine Auswerteeinheit ausgegeben werden.

6. Verfahren nach einem der vorhergehenden Ansprüche, wobei ein weiteres modulspezifisches Simulationsmodell (SM), dem eine weitere Modelltypinformation zugeordnet ist, im virtuellen Modul integriert wird.

7. Verfahren nach einem der vorhergehenden Ansprüche, wobei das virtuelle Modul (VM) verschlüsselt wird und derart bereitgestellt wird.

8. Verfahren nach einem der vorhergehenden Ansprüche, wobei das technische System abhängig von einem Ergebnis der ausgeführten Simulation der Module konfiguriert und/oder gesteuert wird (S6).

9. Vorrichtung (100) zum computergestützten Simulieren eines modularen technischen Systems, die mindestens einen Prozessor (P) aufweist, der zum Ausführen eines Verfahrens nach einem der vorhergehenden Ansprüche eingerichtet ist.

10. Computerprogrammprodukt eingerichtet zum Ausführen eines Verfahrens nach einem der Ansprüche 1 bis 8.

11. Computerlesbares Speichermedium mit einem Computerprogrammprodukt nach Anspruch 10.

## Claims

1. Method for computer-aided simulation of a modular technical system, in particular a modular process installation, wherein a processor for a respective real module of the modular technical system is used
a) to read in module-specific data of the real module and to take the module-specific data as a basis for generating a corresponding virtual module (VM) (S1) that comprises
- a controller for controlling a module-specific process, which controller is present as a hardware project or as an emulation,
and
- at least one module-specific simulation model (SM), which has associated model type information, for simulating the module-specific process, wherein the module-specific simulation model (SM) has a first interface (IF1) by way of which cross-model variables of the module-specific simulation model (SM) are interchanged,
and that is designed to replicate the module-specific process controlled by the controller, by means of the module-specific simulation model (SM), and/or the controller of the real module,
and
b) to provide the virtual module (VM) as a data container for a computer-aided simulation of the modular technical system (S2),
wherein the virtual module (VM) is provided as an encapsulated data container,
wherein
c) predefined configuration information of the modular technical system is taken as a basis for selecting real modules of the technical system, providing corresponding virtual modules for the selected real modules and reading said virtual modules into a simulation environment (S3),
and
d) the virtual modules are coupled to one another in the simulation environment on the basis of the configuration information (S4) and a computer-aided simulation of the modular technical system is executed (S5), wherein predefined simulation type information for each virtual module is taken as a basis for replicating a module-specific process controlled by the respective controller, by means of a respective module-specific simulation model (SM), the associated model type information of which complies with the simulation type information, and/or the controller of a respective module-specific process.

2. Method according to Claim 1, wherein the model type information comprises details relating to the type of simulation model, relating to the execution and/or relating to the level of detail of the simulation model (SM).

3. Method according to either of the preceding claims, wherein the module-specific simulation model (SM) has a second interface (IF2) by way of which parameter values and/or functions for the module-specific simulation model (SM) are read in and the module-specific simulation model (SM) is configured thereby (S4).

4. Method according to one of the preceding claims, wherein the module-specific simulation model (SM) comprises a third interface (IF3) for cross-module communication and the third interface (IF3) is used to read in and/or read out state data of a module-specific simulation model (SM).

5. Method according to Claim 4, wherein state data of a module-specific simulation model (SM) are output by way of an evaluation unit.

6. Method according to one of the preceding claims, wherein a further module-specific simulation model (SM), which has further associated model type information, is integrated in the virtual module.

7. Method according to one of the preceding claims, wherein the virtual module (VM) is encrypted and is provided in this way.

8. Method according to one of the preceding claims, wherein the technical system is configured and/or controlled on the basis of a result of the executed simulation of the modules (S6) .

9. Apparatus (100) for computer-aided simulation of a modular technical system, which has at least one processor (P) designed to perform a method according to one of the preceding claims.

10. Computer program product designed to perform a method according to one of Claims 1 to 8.

11. Computer-readable storage medium having a computer program product according to Claim 10.

## Revendications

1. Procédé de simulation assistée par ordinateur d'un système technique modulaire, notamment d'une installation de traitement modulaire, dans lequel, au moyen d'un processeur, on procède aux étapes suivantes pour un module réel correspondant du système technique modulaire
a) importation de données spécifiques au module du module réel correspondant et, en fonction des données spécifiques au module et génération d'un module virtuel (VM) correspondant (S1) comportant
- une unité de commande pour commander un processus spécifique au module disponible sous forme d'un projet matériel ou d'une émulation, et
- au moins un modèle de simulation (SM) spécifique au module auquel est attribuée une information de type de modèle, pour simuler le processus spécifique au module, le modèle de simulation (SM) spécifique au module ayant une première interface (IF1) au moyen de laquelle des variables inter-modèles de simulation (SM) spécifique au module sont échangées,
et qui est configuré de sorte que le processus spécifique au module commandé par l'unité de commande est simulé au moyen du modèle de simulation (SM) spécifique au module et / ou pour reproduire l'unité de commande du module réel,
b) le module virtuel (VM) pour une simulation assistée par ordinateur du système technique modulaire sous forme de conteneur de données (S2) encapsulé, dans lequel le module virtuel (VM) est disposé sous forme de conteneur emballé,
c) en fonction d'une information de configuration prédéfinie du système technique modulaire, sélection de modules réels du système technique, mise à disposition des modules virtuels correspondant aux modules réels sélectionnés et importation de ceux-ci dans un environnement de simulation (S3),
et
d) liaison des modules virtuels des uns aux autres, en fonction de l'information de simulation de configuration dans l'environnement de simulation (S4) et exécution d'une simulation assistée par ordinateur du système technique modulaire (S5), reproduction d'un processus spécifique au module commandé par l'unité de commande correspondante en fonction d'une information prédéfinie de type de simulation pour chaque module virtuel, à l'aide d'un modèle de simulation spécifique au module correspondant (SM) dont l'information de type de modèle attribuée suffit à l'information de type de simulation, et / ou reproduction de la commande d'un processus correspondant spécifique au module.

2. Procédé selon la revendication 1, dans lequel l'information de type de modèle comprend des renseignements sur le type du modèle de simulation, sur l'exécution et /ou sur le niveau de détail du modèle de simulation (SM).

3. Procédé selon l'une des revendications précédentes, dans lequel le modèle de simulation spécifique au module (SM) comporte une deuxième interface (IF2) par l'intermédiaire de laquelle des valeurs de paramètre et / ou des fonctions pour le modèle de simulation spécifique au module (SM) sont importées, assurant ainsi la configuration du modèle de simulation spécifique au module (SM)(S4).

4. Procédé selon l'une des revendications précédentes, dans lequel le modèle de simulation spécifique au module (SM) comporte une troisième interface (IF3) servant à la communication inter-modulaire, des données d'état d'un modèle de simulation spécifique au module (SM) étant importées et / ou exportées grâce à la troisième interface (IF3).

5. Procédé selon la revendication 4, dans lequel des données d'état d'un modèle de simulation spécifique au module (SM) sont fournies par l'intermédiaire d'une unité d'évaluation.

6. Procédé selon l'une des revendications précédentes, dans lequel un module de simulation spécifique au module (SM) supplémentaire, auquel une information de type de modèle supplémentaire est attribuée, est intégré au module virtuel.

7. Procédé selon l'une des revendications précédentes, dans lequel le module virtuel (VM) est chiffré et mis à disposition tel quel.

8. Procédé selon l'une des revendications précédentes, dans lequel le système technique est configuré et / ou commandé en fonction d'un résultat de la simulation effectuée des modules (S6).

9. Dispositif (100) pour assurer la simulation assistée par ordinateur d'un système technique modulaire comportant au moins un processeur (P) conçu pour exécuter un procédé selon l'une des revendications précédentes.

10. Produit de programme informatique conçu pour exécuter un procédé selon l'une des revendications 1 à 8.

11. Support de stockage lisible par ordinateur comportant un produit de programme informatique selon la revendication 10.
